# EUROPEAN PATENT SPECIFICATION

(11) **EP 2 264 898 B1**
(45) Date of publication and mention of the grant of the patent: **22.05.2013**
(21) Application number: 09162989.9
(22) Date of filing: 17.06.2009
(51) Int. Cl.: H03K 17/96, H03K 17/94

(54) **Optical proximity sensor**
Optischer Näherungssensor
Capteur de proximité optique

(43) Date of publication of application: 22.12.2010
(73) Proprietor: OSRAM Opto Semiconductors GmbH, 93055 Regensburg (DE)
(72) Inventor: Chen, Kenny, Shanghai 200001 (CN); Sheng, Frank, Shanghai 200001 (CN); Zhou, Jenny, Shanghai 200256 (CN); Lu, Zhiling, Meilong Town (CN)
(74) Representative: Epping - Hermann - Fischer

(56) References cited:
- EP-A- 0 283 760
- EP-A1- 2 053 450
- DE-A1- 19 908 214
- US-A- 3 621 268

## Description

The invention relates to an optical proximity sensor.

An optical proximity sensor is known from the document DE 32 04 258 A1. The optical proximity sensor described therein comprises a light source and a light detector for detecting light that is emitted by the light source and reflected by an object outside the optical proximity sensor. A signal will be detected at the light detector if an object approaches the optical proximity sensor. The signal at the light detector can cause a switching operation. For example, the optical proximity sensor can be integrated in a hand drier and the hand drier will be started if a person puts his hand below it.

The reflection of light at the surfaces of the transparent cover of the optical proximity sensor can cause interferences of the detector signal. In order to reduce the interference signal caused by light reflections at the transparent cover, the document DE 32 04 258 A1 proposes to arrange the light source and the light detector on different sides of a non-transparent circuit board. The circuit board is arranged perpendicularly to the non-transparent cover. In this way, the non-transparent circuit board shields the light detector from reflections of light emitted by the light source at the transparent cover.

The arrangement of the light source and the light detector on a circuit board, which is arranged perpendicularly to the transparent cover of the optical proximity sensor, is difficult or even impossible if the space behind the transparent cover is very limited. This is particularly the case if the optical proximity sensor is arranged in a touch panel.

EP2053450 discloses a display device with a light detection sensor with reduced noise. In the said sensor, two light receiving elements (photo sensor) are arranged on the same plane, one of them being a reference cell that directly faces an opaque black mask.

The invention is based on the object of specifying an optical proximity sensor which is distinguished in particular by an improved reduction of interference signals and a compact size.

This object is achieved by means of an optical proximity sensor comprising the features of patent claim 1. The dependent claims relate to advantageous configurations and developments of the invention.

An optical proximity sensor according to a preferred embodiment comprises a light source and a first light detector. In particular, the first light detector can detect light that is emitted by the light source and reflected by an object outside the optical proximity sensor. The optical proximity sensor comprises a transparent cover arranged over the light source and the first light detector. The transparent cover is transparent for the light emitted by the light source which can be visible light or preferably infrared light.

Furthermore, the optical proximity sensor comprises a second light detector. The second light detector can be of the same type as the first light detector, e.g. both the first light detector and the second light detector can be embodied as radiation-sensitive semiconductor chips.

A region of the transparent cover is covered with a non-transparent coating, wherein the region of the transparent cover that is covered with the non-transparent coating is arranged over the second light detector. The non-transparent coating absorbs or reflects light which is emitted by the light source. In this way, the second light detector is shielded from light which is emitted by the light source and reflected back in the direction to the optical proximity sensor.

In contrast to the second light detector, the first light detector is advantageously arranged below a region of the transparent cover which is not covered with the non-transparent coating. Therefore, the first light detector can detect light emitted from the light source and reflected at an object nearby the optical proximity sensor.

Preferably, the first light detector and the second light detector are connected to an evaluation circuit, wherein the evaluation circuit is advantageously adapted to evaluate the difference between a first signal detected by the first light detector and a second signal detected by the second light detector.

The first light detector can detect light that is emitted by the light source, transmitted through the transparent cover, reflected by an external object and transmitted again through the transparent cover. If there is no light reflecting object nearby the transparent cover, the first light detector will ideally detect no signal. If, however, the light emitted by the light source is reflected by an object outside the optical proximity sensor, the first light detector will detect light reflected from the object and determine the presence of the object in this way.

The light detected by the first light detector may not only contain light which is reflected by an object outside the optical proximity sensor, but also light which is reflected at the surfaces of the transparent cover of the optical proximity sensor.

In particular, a fraction of the light which is emitted by the light source is reflected towards the first light detector at the inside surface of the transparent cover, i.e. the surface of the transparent cover which faces the light source and the first and second light detector. Furthermore, a fraction of the light which is emitted by the light source and penetrates into the transparent cover is reflected back at the outside surface of the transparent cover, i.e. at the interface between the transparent cover and the ambient material, for example air.

Light which is reflected back at the inside surface and/or at the outside surface of the transparent cover in this way leads to an unwanted interference signal at the first light detector.

The second light detector is advantageously used to detect the interference signal which is caused by light reflections at the surfaces of the transparent cover in order to deduct it from the measurement signal at the first light detector. Light which is emitted by the light source and reflected by an object outside the optical proximity sensor cannot reach the second light detector because the region of the transparent cover which is arranged over the second light detector is covered with the non-transparent coating.

Preferably, the non-transparent coating is arranged on a region of the outside surface of the transparent cover. Because the inside surface of the transparent cover which faces the second light detector is not covered with a non-transparent coating, the second light detector can detect light which is reflected at the inside surface of the transparent cover. Furthermore, the second light detector detects also light which is emitted from the light source, penetrates into the transparent cover and is reflected at the outside surface of the transparent cover in the direction to the second light detector.

The evaluation circuit which is connected to the first light detector and the second light detector is preferably adapted to deduct the interference signal measured with the second light detector from the measurement signal detected with the first light detector. The difference signal which is calculated in this way is the signal of interest, namely the intensity of the light which is reflected by an object outside the optical proximity sensor. In this way, interferences are suppressed and the sensitivity and reliability of the optical proximity sensor are improved.

In a preferred embodiment, the light source, the first light detector and the second light detector are arranged on a common carrier. The carrier can be a circuit board, in particular a printed circuit board (PCB). In particular, the carrier can be aligned in parallel to the transparent cover. In this way, an optical proximity sensor with an advantageously small height can be achieved.

Preferably, also the evaluation circuit is arranged on the common carrier.

The first light detector and the second light detector are arranged advantageously in such a way that the interference signal which is caused by reflections at the non-transparent cover is similar at the first light detector and the second light detector. Preferably, the light source has a main radiation direction, and the first light detector and the second light detector are arranged in a common plane which is perpendicular to the main radiation direction. Particularly preferable, the first light detector and the second light detector are at the same distance from the light source. In this way, it is achieved that light which is reflected from the transparent cover in the direction of the first light detector and the second light detector is reflected at the same reflection angle.

In a preferred embodiment, the light source is a light emitting diode chip. In particular, the light emitting diode chip can emit infrared light which is not visible for the human eye. This is particularly advantageous if the optical proximity sensor is integrated in a touch panel.

Preferably, the first light detector and the second light detector are semiconductor chips. The optical proximity sensor can be advantageously thin if the light source, the first light detector and the second light detector are embodied as semiconductor chips. Furthermore, the evaluation circuit is preferably an integrated circuit which is arranged on a common circuit board with the light emitting diode chip and the detector chips.

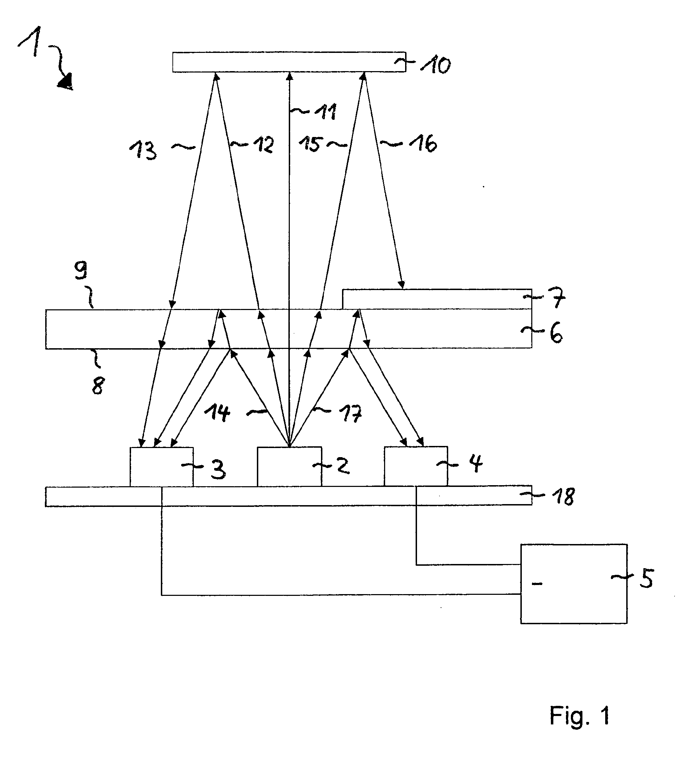

The invention is explained in more detail below on the basis of an exemplary embodiment in connection with FIG. 1.

FIG. 1 shows a schematic graphical illustration of a cross-section through an optical proximity sensor in accordance with an exemplary embodiment of the invention.

The optical proximity sensor 1 which is shown in FIG. 1 comprises a light source 2 which emits light through a transparent cover 6 of the optical proximity sensor 1. The light source 2 is preferably a light emitting diode chip, in particular an infrared light emitting diode chip. The light emitting diode chip may be based on a gallium arsenide semiconductor, for example.

Furthermore, the optical proximity sensor 1 comprises a first light detector 3 for detecting light which is emitted by the light source 2 and reflected by an object 10 outside the optical proximity sensor 1. As shown in FIG. 1, a light beam 12 of the light source is reflected at the surface of an object 10 after having passed the transparent cover 6, and the reflected light beam 13 impinges on the first light detector 3 after having passed the transparent cover 6 again. The detection of a reflected light beam 13 at the first light detector 3 indicates the presence of an object 10 nearby the optical proximity sensor.

If, on the other hand, there is no object 10 nearby the optical proximity sensor 1, there will be ideally no signal detected at the first light detector 3.

However, an interference signal may occur at the first light detector 3 due to light reflections at the inside surface 8 and the outside surface 9 of the transparent cover 6. As shown in FIG. 1, the inside surface of the transparent cover 6 faces the light source 2 and the outside surface 7 is remote from the light source 2. A light beam 14 of the light source 2 is partly reflected at the inside surface 8 in the direction to the first light detector 3. Furthermore, a part of the light beam 14 penetrates into the transparent cover 6 and is reflected at the outside surface 9 of the transparent cover 6 into the direction of the first light detector 3. Therefore, the first light detector 3 detects the light 13 reflected by the object 10, which is the signal of interest, and in addition, an interference signal which is composed of light reflected at the inner surface 8 and the outside surface 9 of the transparent cover 6.

In order to deduct the interference signal from the signal of interest, the optical proximity sensor 1 comprises a second light detector 4. A region of the transparent cover 6 which is arranged over the second light detector 4 is covered with a non-transparent coating 7. As shown in FIG. 1, a light beam 15 which is emitted by the light source 2 is reflected at the object 10 in the direction to the second light detector 4. However, the reflected beam 16 does not reach the second light detector 4 because a region of the transparent cover 6 is covered with the non-transparent coating 7 wherein the reflected light beam 16 is absorbed. In this way, the second light detector 4 is shielded from light 16 which is reflected from an external object 10. For this reason, the second light detector 4 only detects an interference signal which is caused by reflection of light at the inside surface 8 and the outside surface 9 of the transparent cover 6.

As can be seen in FIG. 1, a light beam 17 which is emitted from the light source 2 is partly reflected into the direction of the second light detector 4 at the inside surface 8 of the transparent cover 6. A part of the light beam 16 which penetrates into the transparent cover 6 is partly reflected at the outer surface 9 of the transparent cover 6, and also propagates into the direction of the second light detector 4 after passing the transparent cover 6 again.

Preferably, the first light detector 3 and the second light detector 4 are arranged in the same plane which is perpendicular to a main radiation direction 11 of the light source 2. It is particularly advantageous if the first light detector 3 and the second light detector 4 are arranged at the same distance from the light source 2.

As can be seen in FIG. 1, the first light detector 3 and the second light detector 4 have also the same distance from the transparent cover 6. Therefore, the light beams 14, 17 which are reflected at the inside surface 8 and the outside surface 9 of the transparent cover 6 are reflected at the same angles to the first light detector 3 and the second light detector 4, respectively. It can therefore be assumed that the interference signal which is detected at the second light detector 4 is approximately the same as the interference signal which occurs at the first light detector 3.

Both the first light detector 3 and the second light detector 4 are connected to an evaluation circuit 5 which deducts the interference signal which is measured at the second light detector 4 from the measurement signal which is detected at the first light detector 3. The difference signal which is generated in this way is in good approximation the intensity of the light beam 13 which is reflected at the object 10 outside the optical proximity sensor. Due to the fact that the interference signal which is detected at the second light detector 4 is deducted from the measurement signal which is detected at the first light detector 3, the sensitivity and reliability of the operation of the optical proximity sensor are improved.

Preferably, the first light detector 3, the light source 2 and the second light detector 4 are arranged on a common carrier 18. T The first light detector 3 and the second light detector 4 can be semiconductor chips. The carrier 18 can be a circuit board, for example.

It is possible that also the evaluation circuit 5 is arranged on the carrier 18 (not shown). In this way, it can be achieved that the optical proximity sensor is very flat.

An optical proximity sensor as described herein is in particular suited for a touch panel.

The scope of protection of the invention is not limited to the examples given hereinabove but to the appended claims.

## Claims

1. Optical proximity sensor (1), comprising
- a light source (2),
- a first light detector (3) for detecting light that is emitted by the light source (2) and reflected by an object (10) outside the optical proximity sensor (1), and
- a transparent cover (6) arranged over the light source (2) and the and first light detector (3),
wherein
- the optical proximity sensor (1) comprises a second light detector (4),
- a region of the transparent cover (6) is covered with a non-transparent coating (7),
- the region of the transparent cover (6) that is covered with the non-transparent coating (7) is arranged over the second light detector (4),
- the first light detector (3) and the second light detector (4) are connected to an evaluation circuit (5), wherein
- the light source (2) has a main radiation direction (11), wherein the light source (2), the first light detector (3) and the second light detector (4) are arranged on a common carrier (18) in a common plane perpendicular to the main radiation direction (11), and
- the first light detector (3) and the second light detector (4) are at the same distance from the light source (2).

2. Optical proximity sensor according to claim 1,
wherein the evaluation circuit (5) is adapted to evaluate the difference between a first signal detected by the first light detector (3) and a second signal detected by the second light detector (4).

3. Optical proximity sensor according to claim 1 or 2,
wherein the non-transparent coating (7) is arranged on a region of an outside surface (9) of the transparent cover (6).

4. Optical proximity sensor according to one of the preceding claims,
wherein the carrier (18) is aligned in parallel to the transparent cover (6).

5. Optical proximity sensor according to one of the preceding claims,
wherein the evaluation circuit (5) is arranged on the common carrier (18).

6. Optical proximity sensor according to one of the preceding claims,
wherein the light source (2) is a light emitting diode chip.

7. Optical proximity sensor according to one of the preceding claims,
wherein the first light detector (3) and second light detector (4) are semiconductor chips.

## Patentansprüche

1. Optischer Näherungssensor (1), umfassend:
- eine Lichtquelle (2),
- einen ersten Lichtdetektor (3) zur Detektion von Licht, das durch die Lichtquelle (2) emittiert und durch ein Objekt (10) außerhalb des optischen Näherungssensors (1) reflektiert wird, und
- eine transparente Abdeckung (6), die über der Lichtquelle (2) und dem ersten Lichtdetektor (3) angeordnet ist, wobei
- der optische Näherungssensor (1) einen zweiten Lichtdetektor (4) aufweist,
- ein Bereich der transparenten Abdeckung (6) mit einer nicht-transparenten Beschichtung (7) bedeckt ist,
- der Bereich der transparenten Abdeckung (6), der mit der nicht-transparenten Beschichtung (7) bedeckt ist, über dem zweiten Lichtdetektor (4) angeordnet ist,
- der erste Lichtdetektor (3) und der zweite Lichtdetektor (4) mit einer Auswertungsschaltung (5) verbunden sind, wobei
- die Lichtquelle (2) eine Hauptabstrahlrichtung (11) aufweist, wobei die Lichtquelle (2), der erste Lichtdetektor (3) und der zweite Lichtdetektor (4) auf einem gemeinsamen Träger (18) in einer gemeinsamen Ebene angeordnet sind, die senkrecht zur Hauptabstrahlrichtung (11) verläuft, und
- sich der erste Lichtdetektor (3) und der zweite Lichtdetektor (4) im selben Abstand von der Lichtquelle (2) befinden.

2. Optischer Näherungssensor nach Anspruch 1, wobei die Auswertungsschaltung (5) eingerichtet ist, den Unterschied zwischen einem ersten Signal, das durch den ersten Lichtdetektor (3) detektiert wird, und einem zweiten Signal, das durch den zweiten Lichtdetektor (4) detektiert wird, auszuwerten.

3. Optischer Näherungssensor nach Anspruch 1 oder 2,
wobei die nicht-transparente Beschichtung (7) auf einem Bereich einer Außenfläche (9) der transparenten Abdeckung (6) angeordnet ist.

4. Optischer Näherungssensor nach einem der vorhergehenden Ansprüche,
wobei der Träger (18) parallel zur transparenten Abdeckung (6) ausgerichtet ist.

5. Optischer Näherungssensor nach einem der vorhergehenden Ansprüche,
wobei die Auswertungsschaltung (5) auf dem gemeinsamen Träger (18) angeordnet ist.

6. Optischer Näherungssensor nach einem der vorhergehenden Ansprüche,
wobei die Lichtquelle (2) ein LED-Chip ist.

7. Optischer Näherungssensor nach einem der vorhergehenden Ansprüche,
wobei der erste Lichtdetektor (3) und zweite Lichtdetektor (4) Halbleiterchips sind.

## Revendications

1. Capteur optique de proximité (1) comprenant
une source de lumière (2),
un premier photodétecteur (3) pour détecter de la lumière émise par la source de lumière (2) et réfléchie par un objet (10) situé à l'extérieur du capteur optique de proximité (1),
et
un couvercle transparent (6) disposé sur la source de lumière (2) et sur le premier photodétecteur (3),
où
le capteur optique de proximité (1) comprend un second photodétecteur (4),
une région du couvercle transparent (6) est couverte par un revêtement non transparent (7), la région du couvercle transparent (6) qui est recouverte du revêtement non transparent (7) est disposée sur le second photodétecteur (4), le premier (3) et le second photodétecteur (4) sont connectés à un circuit d'évaluation (5),
où
la source de lumière (2) a une direction de rayonnement principale (11), où la source de lumière (2), le premier photodétecteur (3) et le second photodétecteur (4) sont disposés sur un support commun (18) dans un plan commun perpendiculaire à la direction de rayonnement principale (11), et
le premier photodétecteur (3) et le second photodétecteur (4) sont situés à la même distance de la source de lumière (2).

2. Capteur optique de proximité selon la revendication 1, dans lequel le circuit d'évaluation (5) est conçu pour évaluer la différence entre un premier signal détecté par le premier photodétecteur (3) et un second signal détecté par le second photodétecteur (4).

3. Capteur optique de proximité selon la revendication 1 ou la revendication 2, dans lequel le revêtement non transparent (7) est disposé sur une région d'une surface extérieure (9) du couvercle transparent (6).

4. Capteur optique de proximité selon l'une quelconque des revendications précédentes, dans lequel le support (18) est aligné parallèlement au couvercle transparent (6).

5. Capteur optique de proximité selon l'une quelconque des revendications précédentes, dans lequel le circuit d'évaluation (5) est disposé sur le support commun (18).

6. Capteur optique de proximité selon l'une quelconque des revendications précédentes, dans lequel la source de lumière (2) est une puce à diode électroluminescente.

7. Capteur optique de proximité selon l'une quelconque des revendications précédentes, dans lequel le premier photodétecteur (3) et le second photodétecteur (4) sont des puces à semiconducteur.
